# EUROPEAN PATENT SPECIFICATION

(11) **EP 1 845 762 B1**
(45) Date of publication and mention of the grant of the patent: **25.05.2011**
(21) Application number: 06712598.9
(22) Date of filing: 30.01.2006
(51) Int. Cl.: H05K 3/46, H05K 3/18

(54) **MULTILAYER PRINTED WIRING BOARD**
MEHRSCHICHTIGE LEITERPLATTE
CARTE DE CABLAGE IMPRIMEE MULTICOUCHE

(30) Priority: 02.02.2005 JP 2005026898
(43) Date of publication of application: 17.10.2007
(73) Proprietor: IBIDEN CO., LTD., Ogaki-shi, Gifu 503-0917 (JP)
(72) Inventor: WU, Youhong, Ibigawacho, Ibi-gun Gifu, 5010695 (JP)
(74) Representative: Grünecker, Kinkeldey, Stockmair & Schwanhäusser Anwaltssozietät
(86) International application number: PCT/JP2006/301455
(87) International publication number: WO 2006/082785

(56) References cited:
- EP-A- 1 011 139
- EP-A- 1 117 283
- EP-A- 1 154 480
- JP-A- 2000 165 046
- JP-A- 2000 165 046
- JP-A- 2003 218 531
- JP-A- 2004 335 506
- JP-A- 2004 335 506

## Description

### Field of the Invention

The present invention relates to a multi-layer printed wiring board. More specifically, the present invention relates to a buildup multi-layer printed wiring board preferably used for a package substrate for mounting an IC chip.

### Background of the Invention

In a buildup-type multi-layer printed wiring board constituting a package for IC chips, inter-layer insulation resin is formed on both surfaces or one surface of a core substrate upon which throughholes are made with a drill. Then, via holes used for interlayer conduction are opened by laser or photoetching to form an inter-layer resin insulation layer. On the inner wall of the via hole is formed a conductor layer by plating or the like. Then, a pattern is made by using etching or the like so as to form a conductor circuit. Moreover, a buildup multi-layer printed wiring board is made by repetitively forming an inter-layer insulation layer and a conductor layer. In the latest buildup multi-layer wiring board, a conductor layer (cover plated layer) is placed such that it covers the surface of a throughhole and a via hole is formed on the cover plated layer in order to increase wiring density of the throughhole and buildup layer. Similarly a stacked via structure (i.e., a filled via is formed by filling a via hole with a filler, and another filled via is formed right above the filled via) has been used to shorten the length of wiring.

Patent literatures 1 and 2 are related to conventional buildup multi-layer wiring boards having throughholes with cover plated layers and conventional buildup multi-layer wiring boards with filled vias.
Patent Literature 1: Japanese Unexamined Patent Publication No. 2001-127435
Patent Literature 2: Japanese Unexamined Patent Publication No. H11.251749
EP 1117283 discloses a printed wiring board and its manufacturing method for fabricating a high-density wiring and a highly-reliable connection between conductor layers.

### Disclosure of the Invention

### Problems that the Invention is to Solve

If a stacked via structure is adopted so as to shorten the length of wiring, as described above, the reliability of the via hole tends to decline, so much so that it is difficult to make the diameter of the via hole smaller. In general, if the bottom diameter of a via hole is small, the contact area between the conductor formed on the via hole and the land becomes small, and the bonding strength between the via hole and the land declines. When a heat cycle test or the like is performed, connection resistance tends to increase between them.

In the via hole of the buildup multi-layer wiring board, an electroless plating film is formed before an electrolytic plating film. The electroless plating film, which is formed first, is fragile because it contains organic materials, hydrogen molecules, hydrogen atoms, and the like. Therefore, cracks may tend to occur in the electroless plating film. Also, an electroless plating film tends to detach from a land if warping occurs on the printed wiring board at a time when IC chips are mounted, because an electroless plating film has lower ductility and cannot warp accordingly.

The present invention was designed to solve the abovementioned problems. The object of the invention is to provide a multi-layer printed wiring board that avoids decrease in connection reliability by forming a filled via right above a filled via of a small diameter.

### Means of Solving the Problems

After intense study, the present inventor found that the reliability of via holes declines in specific sites on a multi-layer printed wiring board.
It has been found by simulation that stress applied to the bottom of a filled via on the second interlayer insulation layer (hereinafter referred to as "the second filled via") formed right above a filled via on the first interlayer insulation layer (hereinafter referred to as "the first filled via") is smaller than stress applied to the bottom of the first filled via during a heat cycle.

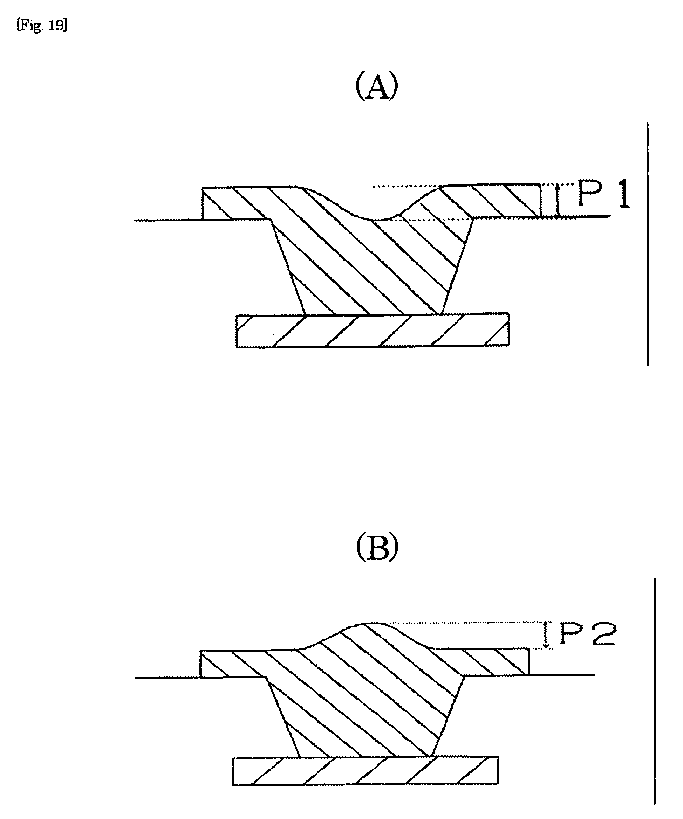

According to Claim 1, the bottom diameter of a filled via on the second interlayer insulation layer formed right above a filled via on the first interlayer insulation layer is made smaller than the bottom diameter of the filled via on the first interlayer insulation layer, and thus integration degree is increased by using via holes of a small radius, and reduction in connection reliability is avoided. In the present invention, the term "filled via" is defined as a via whose concave depth (extent of a dent from the upper end face) P 1 is 7µm or less as shown in Fig. 19 (A) and a via whose convex height (extent of a bump from the upper flat surface) P2 is 7µm or less as shown in Fig. 19 (B).

In addition, the first filled via can be formed on the cover-like conductor layer (cover plated layer). If the first filled via is formed on the cover-like conductor layer, the cover-like conductor layer is deformed on a large scale and in a complicated manner, because physical properties are different between a throughhole and the insulative substrate forming the core. Therefore, the bottom of the first filled via tends to receive large stress.

### Brief Explanation of the Drawings

[Fig. 1] A process drawing showing the production method of the multi-layer printed wiring board according to the first embodiment of the present invention.
[Fig. 2] A process drawing showing the production method of the multi-layer printed wiring board according to the first embodiment.
[Fig. 3] A process drawing showing the production method of the multi-layer printed wiring board according to the first embodiment.
[Fig. 4] A process drawing showing the production method of the multi-layer printed wiring board according to the first embodiment.
[Fig. 5] A process drawing showing the production method of the multi-layer printed wiring board according to the first embodiment.
[Fig. 6] A process drawing showing the production method of the multi-layer printed wiring board according to the first embodiment.
[Fig. 7] A sectional view of the multi-layer printed wiring board according to the first embodiment.
[Fig. 8] A sectional view showing an IC chip mounted the multi-layer printed wiring board according to the first embodiment.
[Fig. 9] A plan view showing the cover plated layers of throughholes.
[Fig. 10] A table showing the assessment results of examples.
[Fig. 11] A table showing the assessment results of examples.
[Fig. 12] A table showing the assessment results of examples.
[Fig. 13] A table showing the assessment results of examples and comparative examples.
[Fig. 14] A table showing the assessment results of examples.
[Fig. 15] A table showing the assessment results of examples.
[Fig. 16] A table showing the assessment results of examples.
[Fig. 17] A table showing the assessment results of examples.
[Fig. 18] A table showing the assessment results of examples.
[Fig. 19] An explanatory drawing showing the filled via according to the present invention. Explanation of Reference Numerals

30. Substrate
34. Conductor circuit
36. Throughhole
36a. Cover plated layer (throughhole land)
36b. Sidewall conductor layer
36d. Cover plated layer (throughhole land)
40. Resin filled layer
50. Interlayer resin insulation layer
58. Conductor circuit
60. Filled via
70. Solder resist layer
71. Opening
78U, 78D. Solder bump
160. Filled via

### The Best Mode for Implementing the Invention

### [First Embodiment]

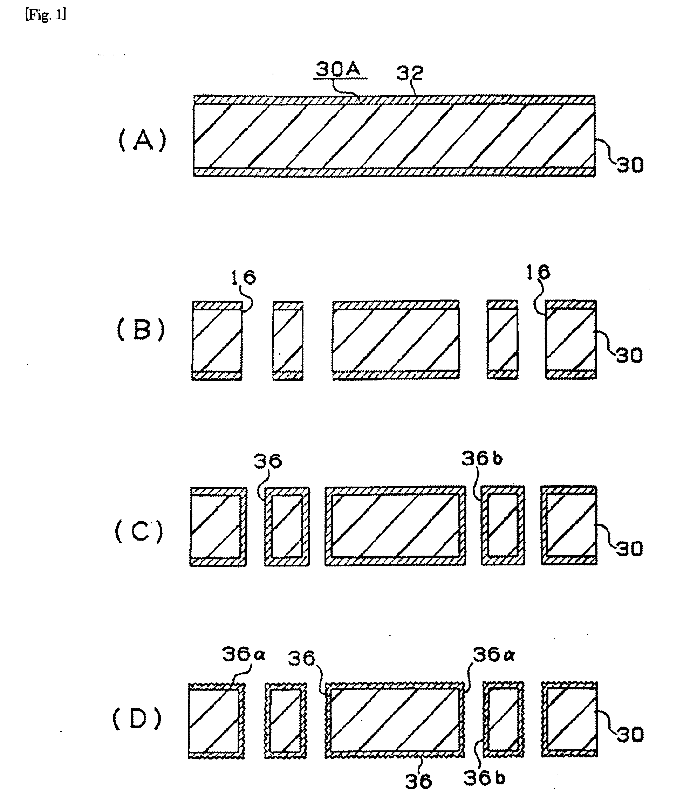

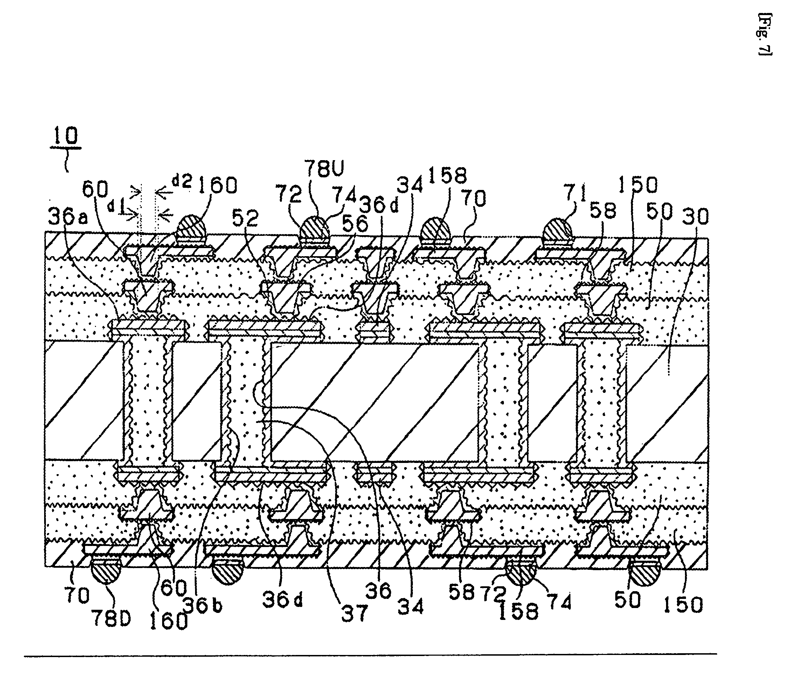

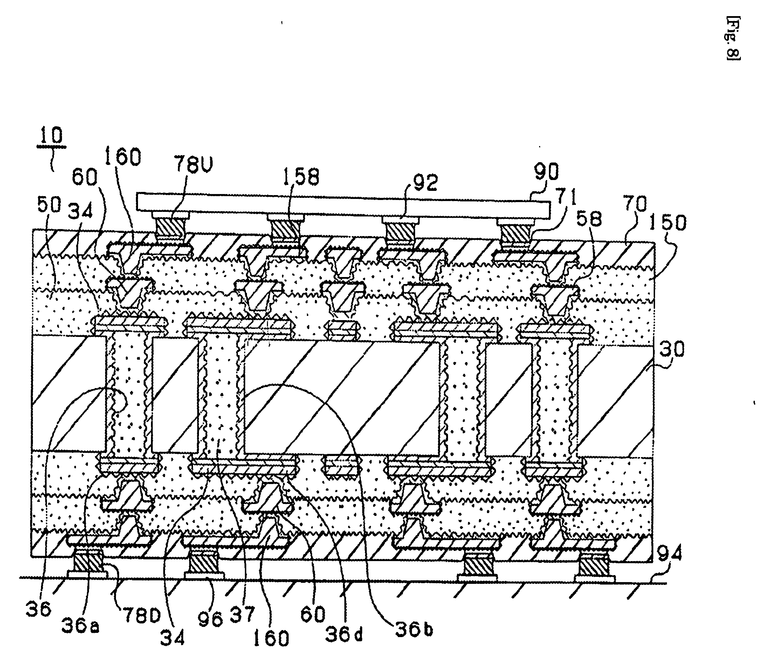

A description of the structure of a multi-layer printed wiring board 10 according to the first embodiment of the present invention is given below by referring to Fig. 1 ~ Fig. 8. Fig. 7 is a sectional view of the multi-layer printed wiring board. In Fig. 8, an IC chip 90 is mounted on the multi-layer printed wiring board 10 as shown in Fig. 7 and the multi-layer printed wiring board 10 is placed on a daughterboard 94. In the multi-layer printed wiring board 10, as shown in Fig. 7, a conductor circuit 34 is formed on the front surface of a core substrate 30. The front and rear surfaces of the core substrate 30 are connected with each other by a throughhole 36. The throughhole 36 is made up of a sidewall conductor layer 36b and cover plated layers 36a and 36d that constitute a throughhole land. Inside of the sidewall conductor layer 36b is filled with resin fillers 37. An interlayer resin insulation layer 50 and an interlayer resin insulation layer 150 are provided on the cover plated layers (throughhole land) 36a and 36d. The interlayer resin insulation layer 50 has a filled via 60 and a conductor circuit 58, and the interlayer resin insulation layer 150 has a filled via 160 and a conductor circuit 158. A solder resist layer 70 is formed above the filled via 160 and conductor circuit 158. Bumps 78U and 78D are formed on the filled via 160 and conductor circuit 158 through the opening 7 of the solder resist layer 70.

As shown in Fig. 8, a solder bump 78U on the top side of the multi-layer printed wiring board is connected to a land 92 of the IC chip 90. On the other hand, a solder bump 78D on the bottom side is connected to a land 96 of the daughterboard 94.

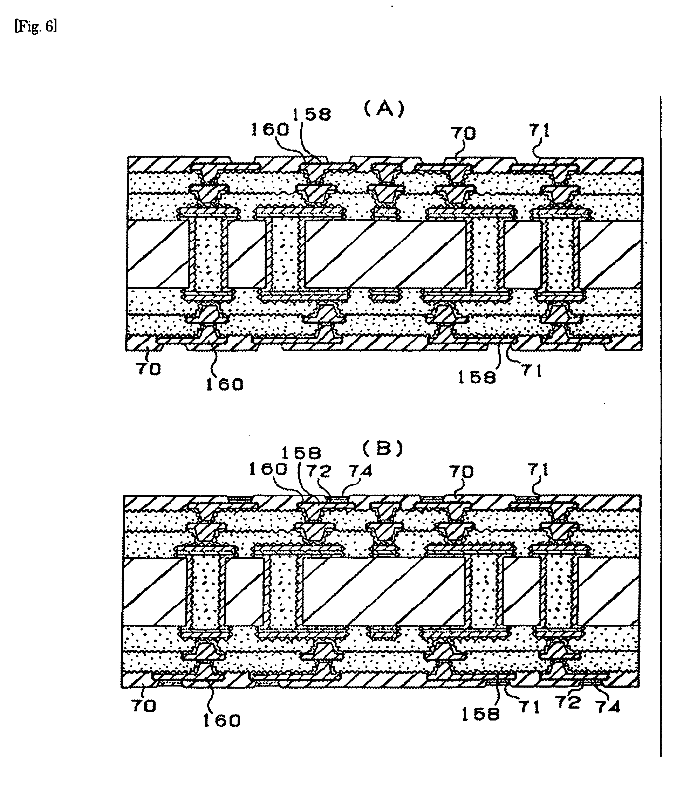

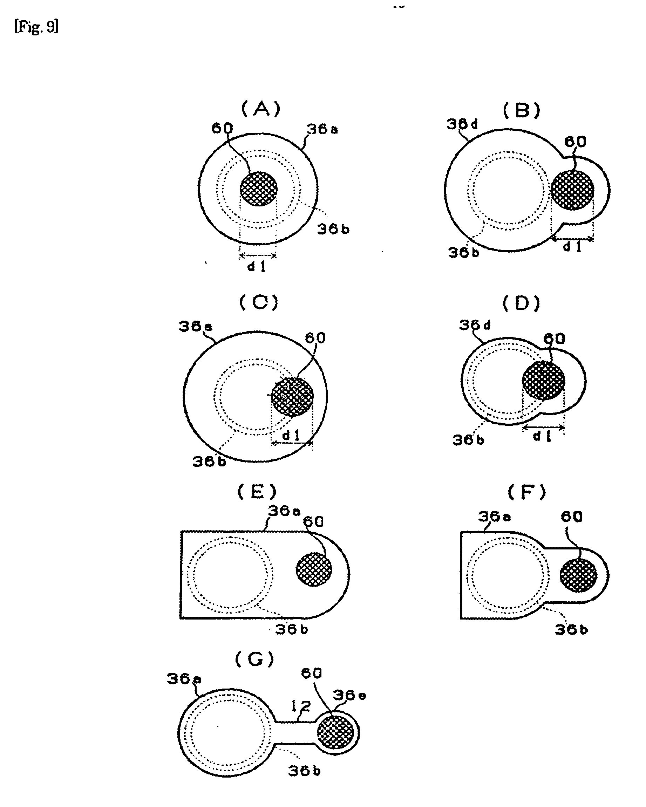

Fig. 9 (A) is a plan view of the cover plated layer (throughhole land) 36a. The opening of a throughhole is made to 0.08mm - 0.25mm in size with a drill. The cover plated layer 36a is made circular. The filled via 60 on the cover plated layer 36a is formed inside the sidewall conductor layer 36b. Here, the bottom of the filled via 60 has a diameter d1 (60) µm. On the other hand, the bottom of the filled via 160 formed in the interlayer insulation layer 150 above the filled via 60, as shown in Fig. 6, has a diameter d2 (45µm).

Fig. 9 (B) is a plan view of the cover plated layer (throughhole land) 36d. The cover plated layer 36d is snowman-shaped (i.e., two semicircles are combined). The bottom section of the filled via 60 on the cover plated layer 36d is formed in a portion which is not above a throughhole. Here, the bottom of the filled via 60 has a diameter d1 (60) µm. On the other hand, the bottom of the filled via 160 formed right above the filled via 60, as shown in Fig. 6, has a diameter d2 (45µm). As shown in Fig. 9 (E) and Fig. 9 (F), the cover plated layer may not be part of a circle. As these examples show, throughholes can be arranged at a narrow pitch if the cover plated layer is protruded horizontally from a throughhole only for the section where a filled via is formed. Also, a throughhole can be filled up with the same material as the sidewall conductor layer instead of using a filler.

The following is the simulation results of stress applied during a heat cycle to a filled via on the cover plated layer 36d and a filled via 160 formed right above the filled via.
Here, 3D thermal stress simulation with a finite element method (FEM) was conducted. If the structure under analysis contains material that is marked in plasticity and creep characteristic such as solder, non-linear thermal stress simulation is required, taking the plasticity and creep characteristic into consideration. Therefore, thermal stress during thermal impact tests on micro vias of a high-density organic package with many layers was analyzed by a multi-scaling (sub-modeling) method. Specifically, a model including the entire substrate was analyzed with a coarse mesh, a variation calculated based on the analysis was used as a boundary condition of a sub-model divided by a minute mesh, and the sections of interest were carefully analyzed. In other words, a coarse model of the package was analyzed, variation was set as a boundary condition of a sub-model, and a non-linear thermal stress analysis was conducted under the conditions of thermal impact tests (55°C ~ 125°C), taking the plasticity of solder into consideration.

As a result, it was found that 130 MPa was applied to the bottom of the filled via 60 on the cover plated layer 36d, and 100 MPa was applied to the bottom of the filled via 160 formed on the upper layer of the filled via 60.

In other words, stress applied to the bottom of a filled via 160 formed on the second interlayer resin insulation layer 150 is smaller than stress applied to the bottom of a filled via 60 formed on the cover-like conductor layer (cover plated layer) 36d during a heat cycle.

In the first embodiment, therefore, bottom diameter d2 of a filled via 160 was made smaller than the bottom diameter d1 of a filled via 60 formed on the cover-like conductor layers (cover plated layers) 36a and 36d. As a result, integration degree was increased by using a filled via of the minimum diameter at each region so as not to reduce connection reliability.

Fig. 9 (C) and Fig. 9 (D) show other exemplary shapes of cover plated layers. Fig. 9 (C) shows a circular cover plated layer 36a, and a filled via 60 is formed above the sidewall conductor layer 36b. Fig. 9 (D) shows a snowman type cover plated layer 36d, and a filled via 60 is formed on the upper side of the sidewall conductor layer 36b. Fig. 9(G) shows a filled via above a land 36e, and the land 36e of the filled via is connected with the cover plated layer 36a and the sidewall conductor layer 36b of a throughhole with the wiring 12. In those cases, it is also preferable that the diameter of the filled via 60 is larger than the diameter of the filled via 160 in terms of connection reliability

A description of the method of producing the abovementioned multi-layer printed wiring board 10 is given below by referring to Figs. 1 ~ 6 as well as Fig. 8.
(1) The starting material was a copper clad laminated plate 30A by laminating copper foils 32 of 5 - 250µm on both surfaces of an insulative substrate 30 of 0.2 ~ 0.8mm in thickness made of glass epoxy resin or BT (Bismaleimide-Triazine) resin (Fig. 1 (A)). First, the copper clad laminated plate is drilled to make a hole 16 (Fig. 1(B)). Then, electroless plating and electrolytic plating (see processes (13) and (15) for plating solution and conditions below) were carried out to form the sidewall conductor layer 36b of the throughhole 36 (Fig. 1 (C)). The opening of the hole 16 was made to 0.1~ 0.25mm ø with a drill, and its pitch 0.15 ~ 0.575mm.

(2) The substrate 30 on which the throughhole 36 is formed was washed with water. After drying, coarse surfaces 36a were formed on the sidewall conductor layer 36b of the throughhole 36 and other surfaces by black oxide treatment using as black oxidizing solution (oxidizing bath) an aqueous solution containing NaOH (10 g/L), NaClO₂ (40 g/L), Na₃PO₄ (6 g/L) and by reduction treatment using as reduction bath an aqueous solution containing NaOH (10 g/L) and NaBH₄ (6 g/L) (Fig. 1 (D)).

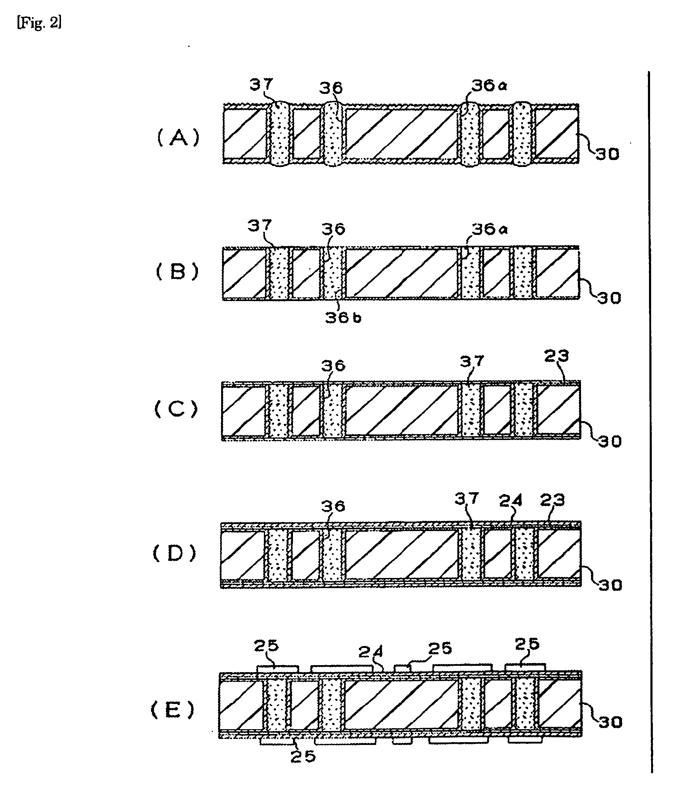

(3) Next, the throughhole 36 was filled with a filler 37 (non-conductive copper filling paste made by Tatsuta Electric Wire & Cable Co., Ltd.; brand name, DD paste) containing copper particles of 10µm in average diameter by using a screen printing method and dried to be solidified (Fig. 2 (A)). In other words, the throughhole was filled with the filler by applying it to the substrate having masks with openings in throughhole portions by using a printing method, and subsequently it was dried and solidified.

Then, the filler 37 that stuck out from the throughhole 36 was removed by belt sander grinding using # 600 belt polishing paper (made by Sankyo Rikagaku Co., Ltd.). Buffing for removing scratches caused by the belt sander grinding was conducted to smooth out the surfaces of the substrate 30 (see Fig. 2 (B)). The substrate 30 thus formed had the sidewall conductor layer 36b of the throughhole 36 and the resin filler 37 tightly attached to each other through the coarse layer 36.

(4) A palladium catalyst (made by Atotec Japan Co., Ltd.) was applied to the surface of the substrate 30 that had been smoothed out in the above (3). Then, it was subjected to electroless copper plating to form an electroless copper plating film 23 of 0.6µm in thickness (see Fig. 2 (C)).

(5) Electrolytic copper plating was carried out under the conditions as shown below to form an electrolytic copper plating film 24 of 15µm in thickness, forming the portion to be the conductor circuit 34 and the portion to be the cover plated layer (throughhole land) to cover the filler 37 of the throughhole 36 (Fig. 2 (D)).

### [Aqueous electrolytic plating solution]

| | |
|---|---|
| Sulfuric acid | 180 g/L |
| Copper sulfate | 80 g/L |
| Additive (made by Atotec Japan; brand name, Caparasid GL) | 1 mL/L |

### [Electrolytic plating conditions]

| | |
|---|---|
| Current density | 1 A/dm² |
| Time | 30 minutes |
| Temperature | room temperature |

(6) On both surfaces of the substrate 30 on which the portions for the conductor circuit and the cover plated layer had been formed, a commercially available photosensitive dry film was attached, and a mask having a pattern was mounted. Then, it was exposed to light (100 mJ/cm²) and developed with 0.8% sodium carbonate to form an etching resist 25 of 15µm in thickness (see Fig. 2 (E)). By adjusting the pattern formed on a mask, one shape can be selected from Fig. 9 (A) ~ Fig. 9 (F) for all the filled vias, or a different shape can be selected from among them for each filled via. It is also possible to select totally different shapes. If there is the sidewall conductor layer 36b in Fig. 9 (A), the filled via 60 needs to be inside the inner wall of the sidewall conductor layer 36b. If the throughhole is filled with the same material, it needs to be inside the opening 16. In Fig. 9 (C) and Fig. 9 (D), the filled via is above the opening 16 if the throughhole is filled with the same material (e.g., copper (may be a combination of electroless copper and electrolytic copper) or conductive paste).

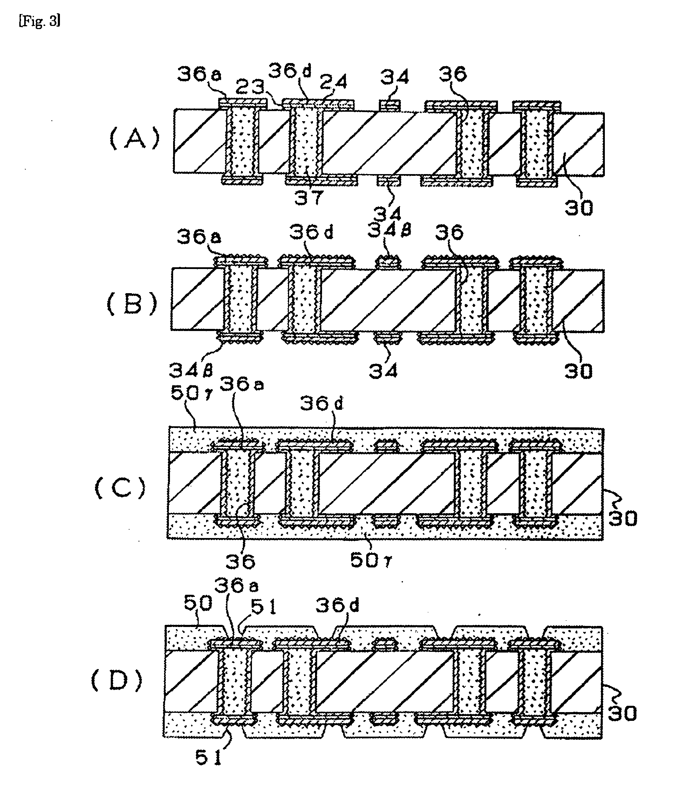

(7) The plated films 23 and 24 and copper foil 32 were removed with etching solution (main ingredient: cupric chloride) from the sections where no etching resist 25 was formed, Then, the etching resist 25 was removed with 5% KOH to form independent conductor circuits 34 and cover plated layers 36a and 36d covering the filler 37 (see Fig. 3 (A)). This method is referred to as a tenting method.

(8) On the surfaces of the conductor circuit 34 and the cover plated layers 36a and 36d that covered the filler 27 was formed a coarse layer (textured layer) 34B of 2.5µm in thickness made of an Cu-Ni-P alloy. On the surface of the coarse layer 348was formed a Sn layer of 0.3µm in thickness (see Fig. 3 (B); the Sn layer is not shown in the drawing).

(9) The interlayer resin insulation layer 50 was formed by the following method: a resin film for the interlayer resin insulation layer (made by Ajinomoto Co., Inc.; brand name, ABF-45SH) 50 ' , which was slightly larger than the substrate, was placed on both surfaces of the substrate; it was preliminarily attached to the substrate under the conditions of 0.45 MPa (pressure), 80°C (temperature), and 10 seconds (pressure bond time) and then sheared; and it was completely attached by using a vacuum laminator (Fig. 3 (C)) in the following manner: the resin film for the interlayer resin insulation layer was completely attached to the substrate under the conditions of 67 Pa (degree of vacuum), 0.47 MPa (pressure), 85°C (temperature), and 60 seconds (pressure bond time), followed by thermosetting for 40 minutes at 170°C.

(10) The opening 51 was formed for a via hole on the interlayer resin insulation layer 50 using CO₂ gas laser (wavelength: 10.4µm) under the conditions of 4.0mm (beam radius), a top hat mode, 3 - 30p seconds (pulse width), 1.0 - 5.0mm (radius of the open hole of a mask), and 1 ~ 3 shots (Fig. 3 (D)). Here, the abovementioned laser conditions for the interlayer resin insulation layer 50 were adjusted in such a way that the bottom diameter of a via hole became · 60 µm. As a result, the bottom diameter of a via hole formed on the cover plated layers 36a and 36d became · 60 µm.

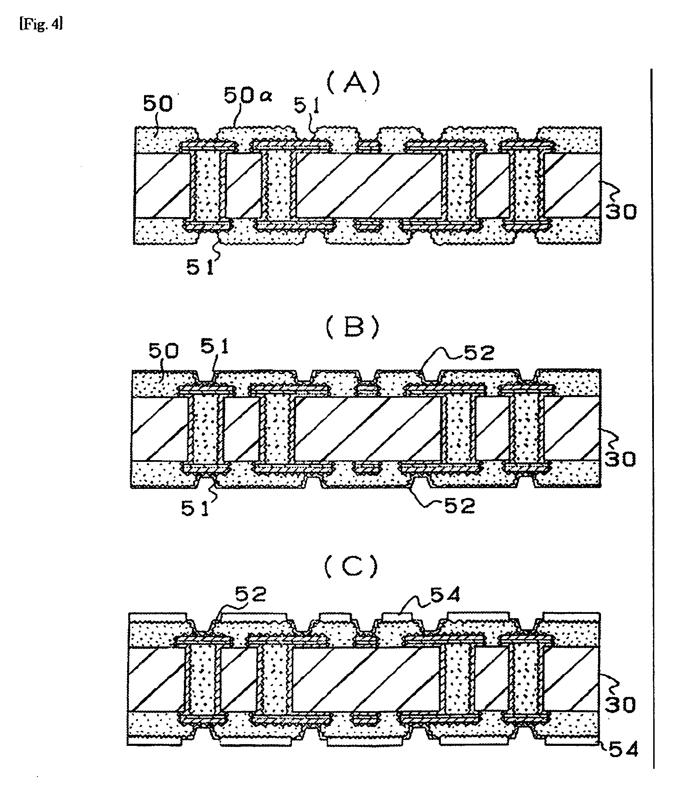

(11) The substrate in which the opening 51 for the filled via had been formed was immersed in a solution containing 60 g/L of permanganic acid for ten minutes at 80°C to remove epoxy resin particles that had remained on the surface of the interlayer resin insulation layer 2. As a result, a coarse surface 50 · was formed on the surface of the interlayer resin insulation layer 50 including the inner wall of the opening 51 for the filled via (Fig. 4(A)).

(12) The above-treated substrate was immersed in a neutralizing solution (made by Shipley Company L.L.C.) and then washed with water.
Furthermore, the nucleus of a catalyst was attached to the surface of the interlayer resin insulation layer and the inner wall of the opening for the via hole by applying a palladium catalyst to the surface of the substrate that had been made coarse on its surface (depth of the coarseness: 3µm). In other words, the substrate was immersed in a catalyst solution containing palladium chloride (PbC₁₂) and stannous chloride (SnC₁₂) in order to deposit metal palladium, thereby providing the catalyst.

(13) The substrate provided with the catalyst was immersed in an aqueous electroless copper plating solution (Thrucup PEA) manufactured by Uemura & Co. Ltd. to form an electroless copper plating film of 0.3 - 3.0µm in thickness on the entire coarse surface. Thus, the electroless copper plating film 52 was formed on the surface of the interlayer resin insulation layer 50 of the substrate including the inner wall of the opening 51 for the via hole (Fig. 4 (B)).

### [Electroless plating conditions]

At 34°C (liquid temperature) for 45 minutes.

(14) A commercially available photosensitive dry film was attached on the substrate on which the electroless copper plating film had been formed, and a mask was mounted. Then, it was exposed to light (110 *mJ*/*cm²)* and developed with 0.8% sodium carbonate aqueous solution to form a plating resist 54 of 25µm in thickness (Fig. 4 (C)).

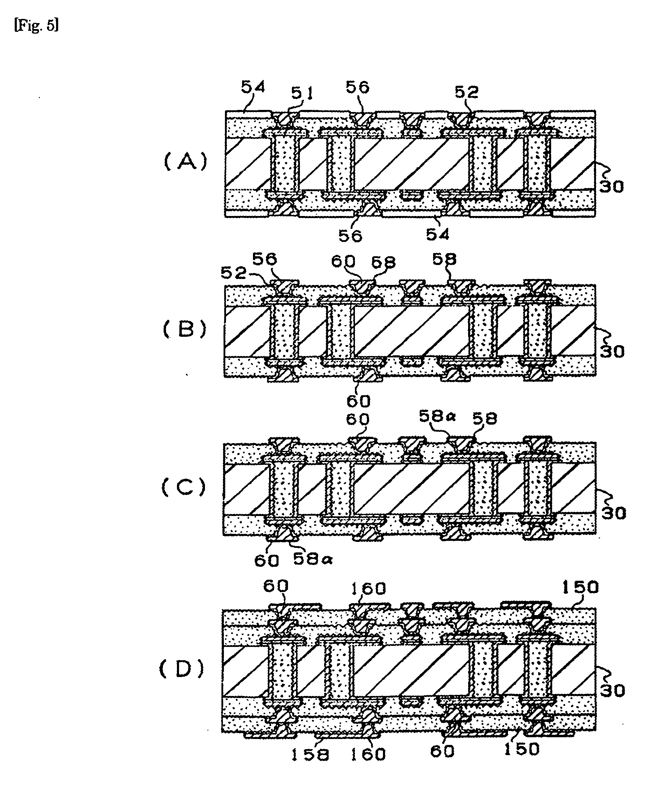

(15) The substrate 30 was washed with water at 50°C to remove grease. Subsequently it was washed with water at 25°C, followed by sulfuric acid. Then, electrolytic plating was carried out under the conditions as shown below to form an electrolytic plating film 56 (Fig. 5 (A)).

### [Electrolytic plating solution]

| | |
|---|---|
| Sulfuric acid | 2.24 mol/L |
| Copper sulfate | 0.26 mol/L |
| Additive | 19.5 mL/L |
| Leveling agent | 50 mg/L |
| Brightening agent | 50 mg/L |

### [Electrolytic plating conditions]

| | |
|---|---|
| Current density | 1 A/dm² |
| Time | 70 minutes |
| Temperature | 22±2°C |

(16) After removing the plating resist 54 with 5% KOH, the electroless plated film under the plating resist was removed by an etching process using a mixture of sulfuric acid and hydrogen peroxide to form independent conductor circuit 58 and filled via 60 (Fig. 5 (B)).

(17) By using the same process as in the above (4), the coarse surface 58 a was formed on the surfaces of the conductor circuit 58 and filled via 60. The conductor circuit 58 on the upper layer was 15µm in thickness (Fig 5 (C)). However, the conductor circuit on the upper layer may be 5 - 25µm in thickness.

(18) By repeating the above processes (9) - (17), an interlayer insulation layer 150, that is, the upper layer that has conductor circuits 158 and filled vias 160 was formed. Thus, a multi-layer wiring board was made (Fig 5(D)). The bottom diameter of the filled via 160 was adjusted to 45µm.

(19) A commercially available solder resist composition 70 was applied in the thickness of 20µm to both surfaces of the multi-layer wiring board and dried for 20 minutes at 70°C followed by 30 minutes at 70°C. After tightly attaching to the solder resist layer 70 a photo mask of 5mm in thickness on which a pattern of the opening section of the solder resist was drawn, it was exposed to ultraviolet rays (1000 mJ/cm²) and then developed with DMTG solution to form the opening 71 of 200µm in diameter (Fig. 6 (A)).
Then, the solder resist layer was solidified by heat processes at 80°C for one hour, at 100°C for one hour, at 120°C for one hour, and at 150°C for three hours to form solder resist pattern layers of 15 - 25µm in thickness that had opening sections.

(20) The substrate on which the solder resist layer 70 had been formed was immersed in an electroless nickel plating solution (pH: 4.5) containing nickel chloride (2.3 x 10 ⁻¹ mol/L), sodium hypophosphite (2.8 x 10⁻¹ mol/L), and sodium citrate (1.6 x 10 -¹ mol/L) to form a nickel plated layer 72 (5µm in thickness) in the opening 71. Subsequently, the substrate was immersed in an electroless gold plating solution containing gold potassium cyanide (7.6 x 10⁻³ mol/L, ammonium chloride (1.9 x 10 ⁻¹ mol/L), sodium citrate (1.2 x 10 ⁻¹ mol/L), and sodium hypophosphite (1.7 x 10 ⁻¹ mol/L) for 7.5 minutes at 80°C to form a gold plated layer 74 of 0.03µm in thickness on the nickel plated layer 72 (Fig. 6 (B)). Besides nickel and gold, a single layer of Sn or precious metal (gold, silver, palladium, platinum, etc.) may be formed.

(21) The opening 71 of the solder resist layer 70 formed on the surface of the substrate for mounting an IC chip was printed with solder paste containing Sn-Pb. After that, the opening of the solder resist layer on the other surface was printed with solder paste containing Sn-Sb. Then, solder bumps (solder bodies) were formed by reflow soldering at 200°C to make a multi-layer printed wiring board having solder bumps 78U and 78D (Fig. 7).

An IC chip 90 was mounted through the solder bumps 78U. Then, the wiring board was mounted on the daughterboard 94 through the solder bumps 78D (Fig. 8).

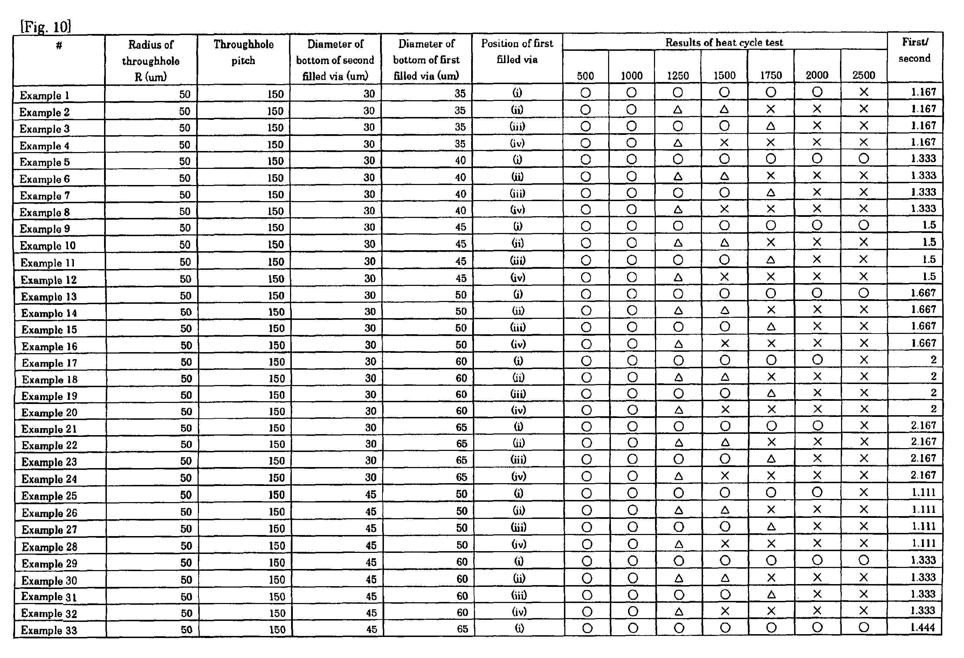

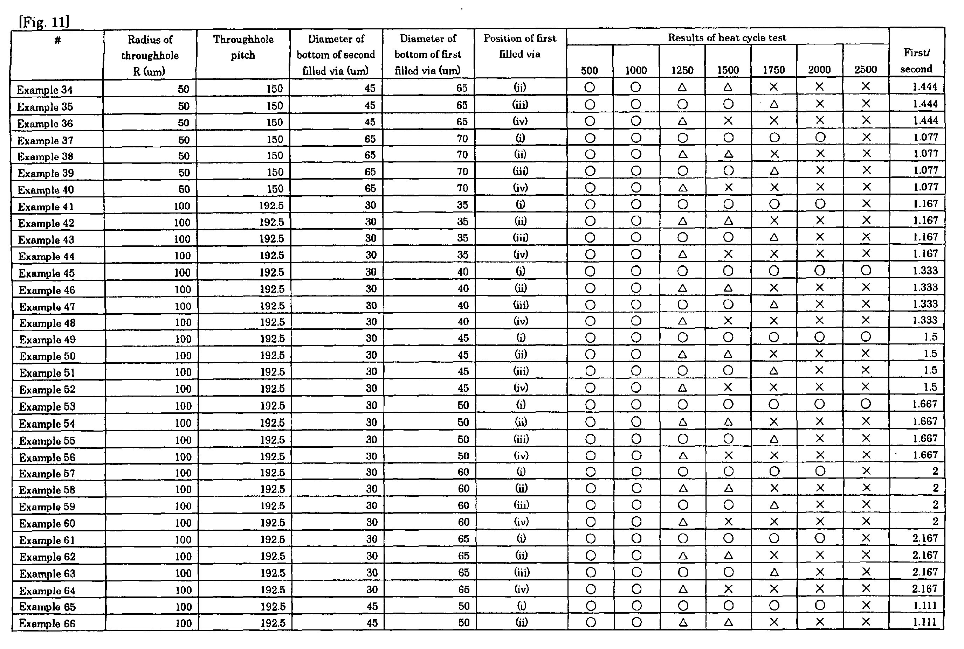

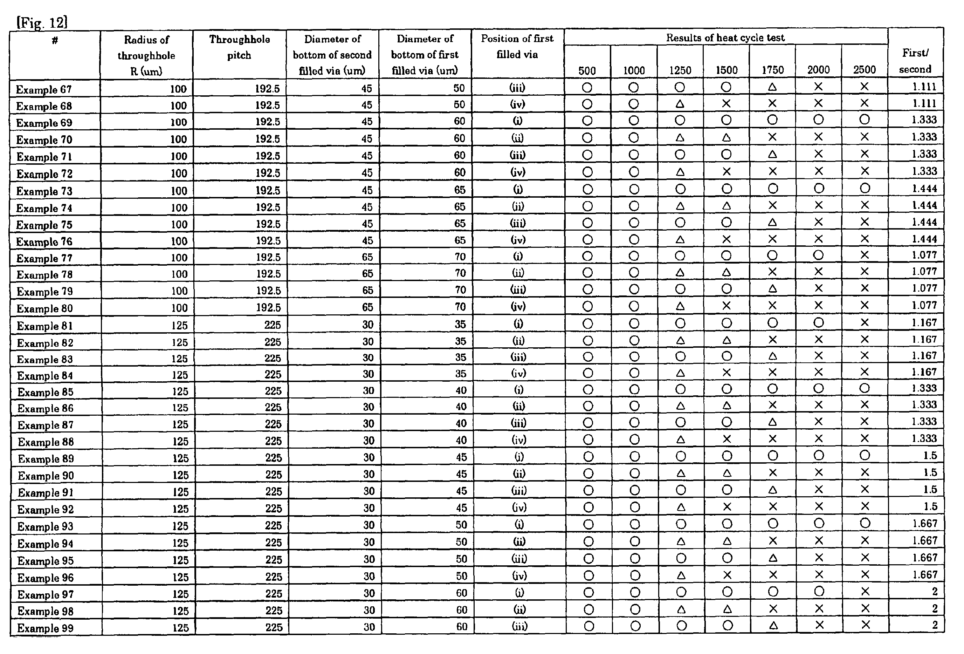

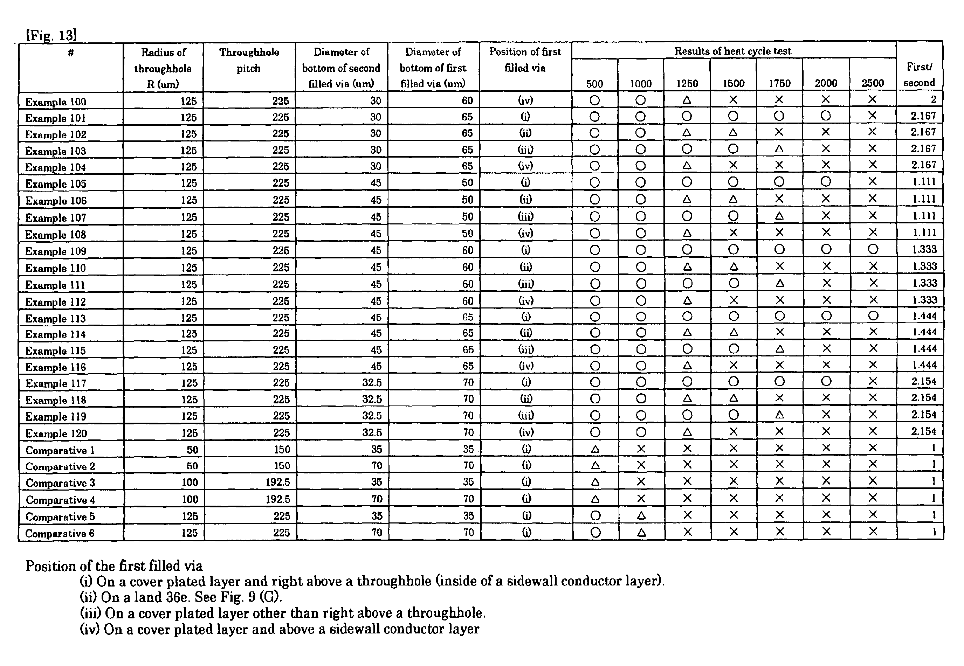

Various examples are given below to demonstrate the effect of the multi-layer printed wiring board 10 according to the first embodiment. First, the rate of change in electric resistance after repeatedly heating and cooling multi-layer printed wiring boards is discussed. Various multi-layer printed wiring boards were made by changing the bottom diameter of the first filled via, the bottom diameter of the second filled via, the shape of the land of the first filled via (see Fig. 9), and the position of the first filled via. The positions of the first via were (j) on the cover plated layer and right above a throughhole (see Fig. 9 (A)); (ii) on the land 36e (see Fig. 9 (G)); (iii) on the cover plated layer other than right above a throughhole (see Fig. 9 (B)); or (iv) on the cover plated layer and above the sidewall conductor layer (see Fig. 9 (C) and Fig. 9 (D)). Multi-layer printed wiring boards of Examples 1 - 120 and Comparative Examples 1 ~ 6 (Fig. 10 - Fig. 13) were made based on the abovementioned first embodiment Specifically the diameter of the opening 16 was varied, as described in the process (1) by referring to Fig. 1 (B), by changing the diameter of a drill used for drilling. The pitch was varied by inputting data on drilling position into the drill. The bottom diameters of the first and second filled vias were altered by adjusting the laser conditions as shown above in the process (10). The positions of the first and second filled vias were changed by inputting data on via hole opening position into a laser processing machine in accordance with the shape of the land of a filled via and the position of the land. The shape of the land of the first filled via was changed by adjusting the pattern of a mask as described in the process (6) by referring to Fig. 2 (E). An IC chip was then mounted on each multi-layer printed wiring board of various examples and comparative examples. Then, a heat cycle test was conducted on those IC-mounted substrates for 2500 cycles (one cycle: - 55 degrees for 5 minutes and 125 degrees for 5 minutes). The electric resistance was measured at the 500th, 1000th, 1250th, 1500th, 1750th, 2000th, and 2500th cycle of the heat cycle test to find the rate of change relative to the initial value (100 x (measured value - initial value) / initial value (%)). Fig. 10 ~ Fig. 13 show the results. In the drawings, the rate of change of electric resistance was shown as follows: "good" (O) if the rate of change was ±5% or less; "normal" (Δ) if it was ±5 ~ 10%; and "poor" (X) if it exceeded ± 10. The target specification was such that the rate of change was ± 10% or less (i.e., "good" or "normal" in assessment) at the 1000th cycle. "Acceptable" ones were ± 10% or less.

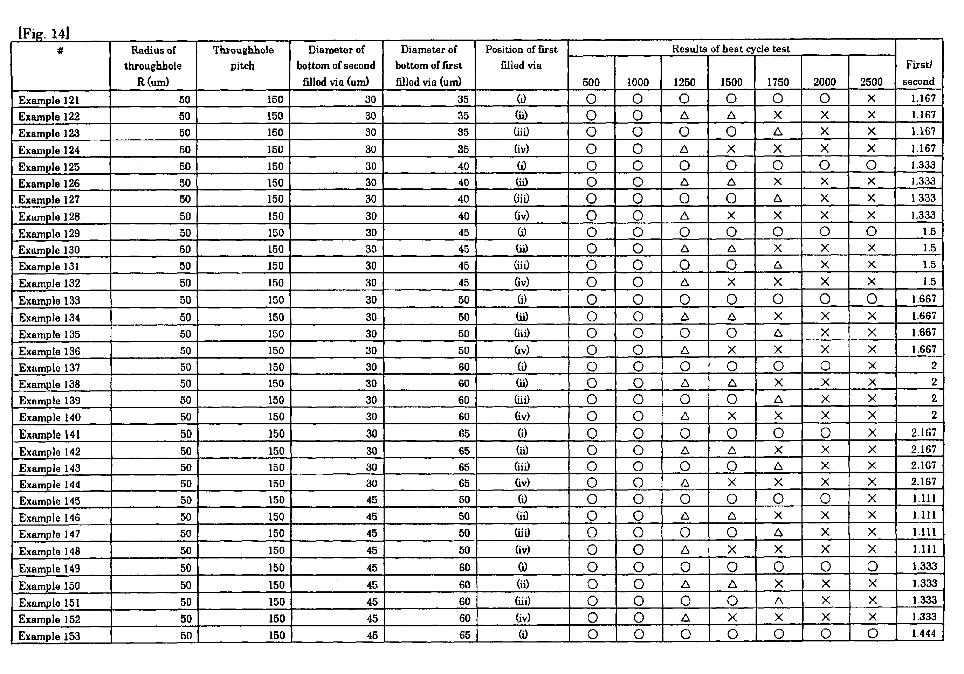

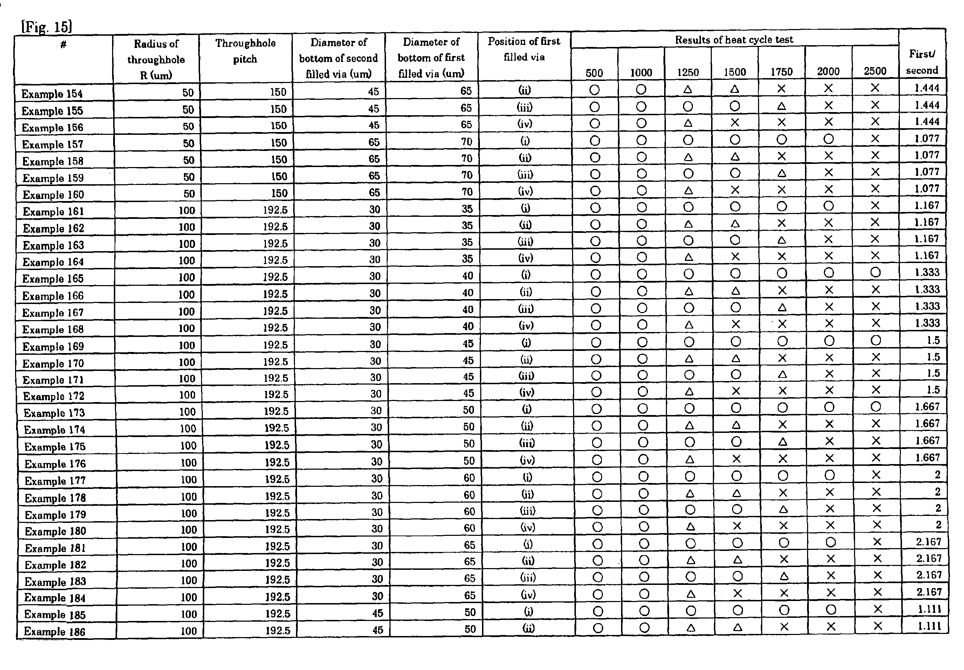

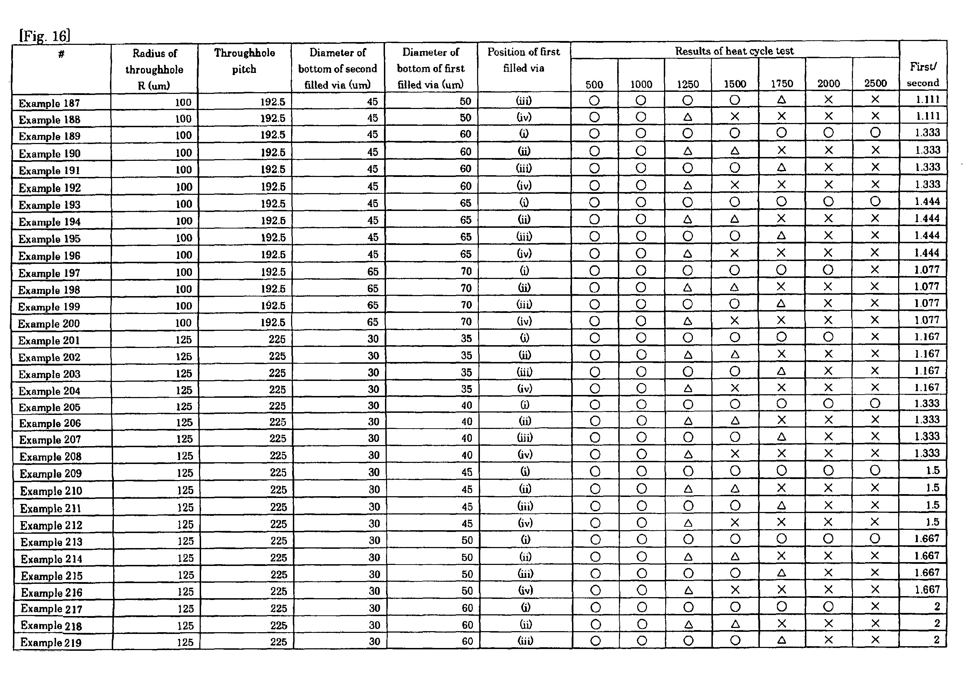

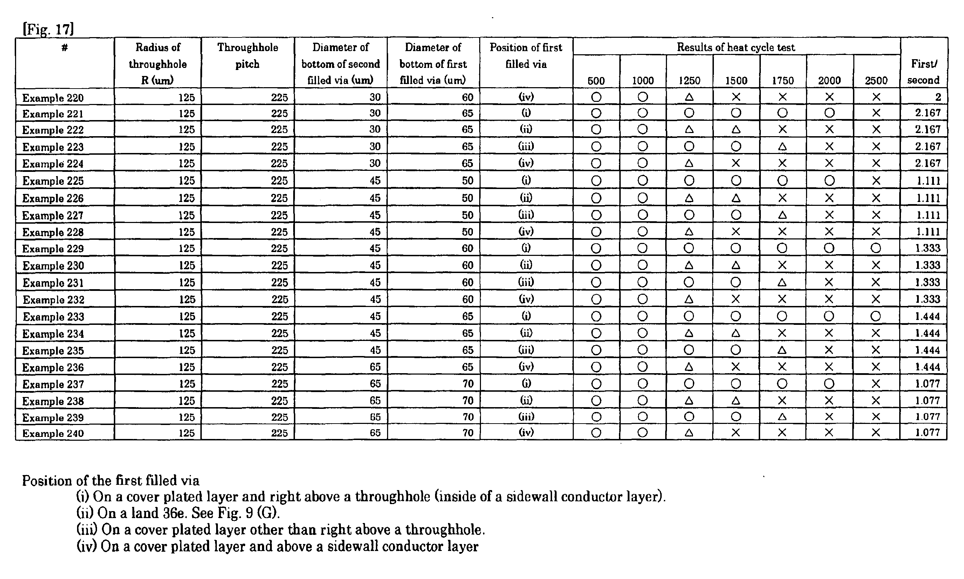

Multi-layer printed wiring boards were made by filling throughholes with the same material as the sidewall conductor layer and referred to them as Examples 121 ~ 240 that correspond to Examples 1~ 120. After mounting IC in the same manner, heat cycle tests were conducted. In this case, the electrolytic copper plating condition inside the opening was 0.1 A/dm². Fig. 14 ~ Fig. 17 show the assessment results of Examples 120~ 240.

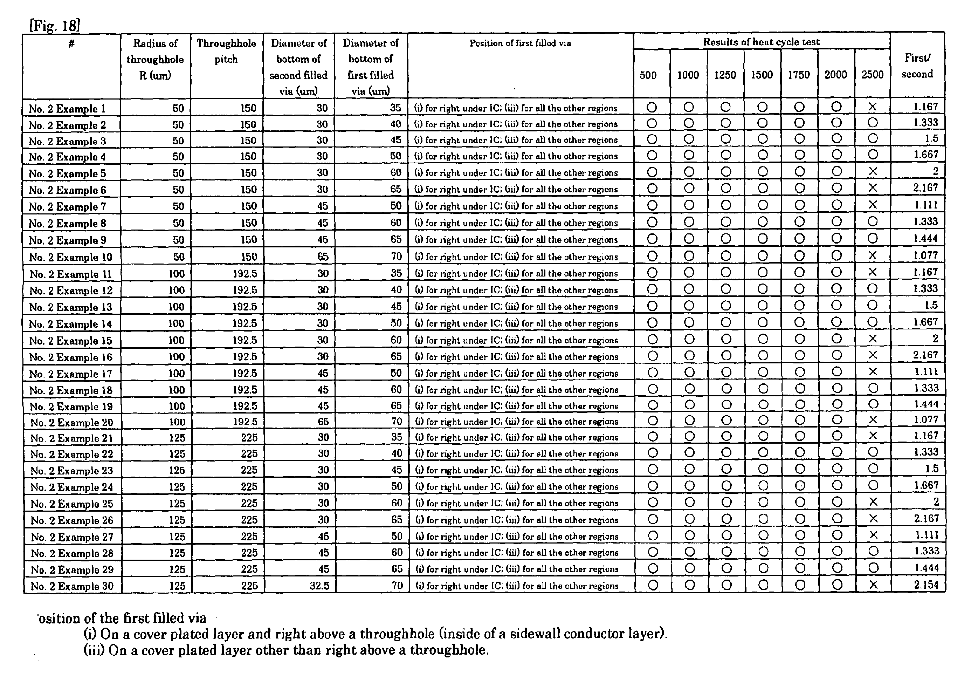

In addition, No. 2 Examples 1 - 30 were made based on Examples 3, 7, 11... , 115, and 119 (the land shape of the first filled via corresponds to Type (iii) in Examples 1 - 120) by making Type (i) land shape for the first filled vias over the throughholes right below IC. In No. 2 Examples 1 - 30, heat cycle tests were also conducted after mounting IC. Then, the results were assessed by measuring connection resistance of a specific circuit containing both of Types (i) and (iii). Fig. 18 shows the assessment results and the shape of filled vias in No. 2 Examples 1~30 including bottom diameters.

According to the assessment results, it was found that Examples 1~ 120 whose bottom diameter of the first filled via was larger than that of the second filled via met the target specification and was acceptable even at the 1250th cycle. On the other hand, comparative examples whose bottom diameter of the first filled via was equal to or less than that of the second filled via was "normal" or "poor" at the target specification cycle, and all of them were "poor" at the 1250th cycle. In Comparative Examples 1 - 6, the bonding between the second filled via and the surface of the first filled via became strong because the bottom diameter of the second filled via was equal to or larger than the bottom diameter of the first filled via. As a result, it became difficult for the second filled via and resin insulation layers around it to deform so as to ease the stress. Therefore, it is speculated that the stress during heating and cooling cycles was concentrated on the land (cover-like conductor layer if the land shape was (i), (iii), and (iv)) of the first filled via and the bottom of the first filled via, which weakened the bonding between the bottom of the first filled via and the land and resulted in a rise of connection resistance.

The comparison between Comparative Examples 1 ~ 4 and Comparative Examples 5 and 6 shows that the target specification was satisfied when the diameter of a throughhole and its pitch were low in density even if the bottom diameter of the first filled via was equal to or less than that of the second filled via. However, the results were poor at the 1000th cycle if the radius of a throughhole was 100µm or less and its pitch was 385µm or less. It is speculated that this was because the latter had stronger stress. One speculated reason is that deformation of the multi-layer printed wiring board was bigger in Comparative Examples 5 and 6 because a throughhole conductor (copper: 16 ppm) that had a thermal expansion coefficient different from that of the insulative substrate 30 (thermal expansion coefficient: 50 ~ 60 ppm) was furnished on the insulative substrate in high density Therefore, it is more significant to apply the present invention to multi-layer printed wiring boards whose throughhole is 100µm or less in radius and pitch is 385µm or less.

According to the results of Examples 1 - 120 at the 1500th, 1750th, and 2000th cycles, it was found that the heat-cycle resistance varied depending on the land shape of the first filled via even if the bottom diameter of the first filled via was larger than the bottom diameter of the second filled via. Long-term reliability is superior in the order of (i), (iii), (ii), and (iv). On the insulative substrate 30, throughholes were formed that were different from the insulative substrate in terms of physical properties such as Young's modulus, Poisson ratio, and thermal expansion coefficient. It is therefore speculated that this was because stress applied to the section between the bottom of first filled via and the land changed depending on various conditions including the land shape of the first filled via, the position of the first filled via, and wiring or no wiring between the land and the throughhole. Since they are different in physical properties, the insulative substrate and throughholes were deformed differently. It is speculated that stress applied to the bottom of the first filled via was larger in (iv) than in (i) ~ (iii) because the bottom of the first filled via was placed on both sides. On the other hand, it is considered that (i) ~ (iii) were superior in heat-cycle resistance because the first filled via was on the throughhole or the insulative substrate. The reason why (iii) was inferior to (i) was considered that inside of a throughhole was small in deformation compared with the insulative substrate because copper, which allowed less deformation due to larger Young's modulus and smaller thermal expansion coefficient compared with the insulative substrate, was formed on the inner wall of the throughhole as a throughhole sidewall conductor. The coarse layer 36 · (see Fig. 1 (D)) of the inner wall might have some influence on the result. Therefore, it is considered that stress applied to the section between the bottom of the first filled via and the land (cover-like conductor layer) became small. Moreover, the land of the first filled via was positioned closer to a throughhole in (iii) than in (ii). It t is therefore considered that (iii) was small in the deformation of the first filled via due to the influence of the throughhole sidewall conductor.

Based on the results at the 2500th cycle, it was found that the ratio of the bottom diameter of the first filled via with respect to the bottom diameter of the second filled via was preferably 1.3 - 1.7. It is considered that this was because the bonding power / stress became substantially equal in this range because of the difference of stress between both sections, even if the bonding force between the bottom of the second filled via and the surface of the first filled via was weaker than the bonding force (adhesive force per unit area x bonding area) between the land of the first filled via (cover-like conductor layer in the case of (i), (iii), and (iv)) and the bottom of the first filled via. (If there is any difference between them, stress is concentrated on the weak side, resulting in problems including detachment.)

The results of Examples 120~240 were similar to those of Examples 1~120.
The results of No. 2 Examples 1~ 30 and those of Examples 1, 5 ...113, 117 (the land of the first filled via was (i) in Examples 1 - 120) were similar. Accordingly, it is desirable that at least the first filled via right below IC is formed right above a throughhole, and that its bottom diameter is formed larger than that of the second filled via. It is speculated that this is because stress right below IC is large due to the difference of thermal expansion coefficient between IC and the insulative substrate.

## Claims

1. A multi-layer printed wiring board, wherein a first interlayer resin insulation layer (50) having a plurality of filled via (60) comprising an electroless plating film and an electrolytic plating film, and a conductor circuit are laminated on a core substrate (30) having a throughhole (36), and wherein a second interlayer resin insulation layer (150), having a plurality of filled via comprising an electroless plating film and an electrolytic plating film, and a conductor circuit are laminated on the first interlayer resin insulation layer (50), **characterized in that**
a cover-like conductor layer (36a) is formed at an end of the throughhole (36) to close the end; a cover-like conductor layer (36a) is formed at an end of the throughhole (36) to close the end;
a part of a filled via (60) on said first interlayer resin insulation layer (50) is placed inside of a sidewall conductor layer (36b) of the throughhole and on the cover-like conductor layer (36a);
the other part of the filled via (60) in said first interlayer resin insulation layer (50) is placed outside of the sidewall conductor layer (36b) of the throughhole and on the cover-like conductor layer (36a);
a bottom diameter of a filled via (160) in the second interlayer insulation layer (150) formed right above the filled via (60) in the first interlayer insulation layer (50) is made smaller than a bottom diameter of the filled via in the first interlayer insulation layer (50), and the diameter of the throughhole is made larger than the bottom diameter of the filled via in the first insulation interlayer.

2. The multi-layer printed wiring board according to claim 1. wherein the filled via in the first interlayer resin insulation layer whose extent of a dent of a central part from the upper end is 7 µm or less from periphery part.

3. The multi-layer printed wiring board according to claim 1 or 2, wherein the filled via in the first interlayer resin insulation layer whose extent of a bump of a central part from the upper end is 7 µm or less from periphery part.

## Patentansprüche

1. Mehrschichtige Leiterplatte, wobei eine erste Zwischerischicht-Harz-Isolierschicht (50) mit einer Vielzahl gefüllter Kontaktlöcher (60), die einen stromlos abgeschiedenen Film und einen elektrolytisch abgeschiedenen Film umfasst, und eine Leiterschaltung auf einem Kern-Substrat (30) laminiert werden, das ein Durchgangsloch (36) aufweist, und eine zweite Zwischenschicht-Harz-Isolierschicht (150) mit einer Vielzahl gefüllter Kontaktlöcher, die einen stromlos abgeschiedenen Film und einen elektrolytisch abgeschiedenen Film umfasst, sowie eine Leiterschaltung auf der ersten Zwischenschicht-Harz-Isolierschicht laminiert werden, **dadurch gekennzeichnet, dass**
eine abdeckungsartige Leiterschicht (36a) an einem Ende des Durchgangslochs (36) ausgebildet ist, um das Ende zu verschließen;
ein Teil eines gefüllten Kontaktlochs (60) in der ersten Zwischenschicht-Harz-Isolierschicht (50) im Inneren einer Seitenwand-Leiterschicht (36b) des Durchgangslochs und an der abdeckungsartigen Leiterschicht (36a) angeordnet ist;
der andere Teil des gefüllten Kontaktlochs (60) in der ersten Zwischenschicht-Harz-Isolierschicht (50) außerhalb der Seitenwand-Leiter-Schicht (36b) des Durchgangslochs und an der abdeckungsartigen Leiterschicht (36a) angeordnet ist;
ein unterer Durchmesser eines gefüllten Kontaktlochs (160) in der zweiten Zwischenschicht-Isolierschicht (150), das unmittelbar oberhalb des gefüllten Kontaktlochs (60) in der ersten Zwischenschicht-Isolierschicht (50) ausgebildet ist, kleiner ausgeführt ist als ein unterer Durchmesser des gefüllten Kontaktlochs in der ersten Zwischenschicht-Isolierschicht (50), und der Durchmesser des Durchgangslochs größer ausgeführt ist als der untere Durchmesser des gefüllten Kontaktlochs in der ersten Isolier-Zwischenschicht.

2. Mehrschichtige Leiterplatte nach Anspruch 1, wobei bei dem gefüllten Kontaktloch in der ersten Zwischenschicht-Harz-Isolierschicht die Ausdehnung einer Vertiefung eines Mittelteils vom oberen Ende 7 µm oder weniger vom Umfangsteil her beträgt.

3. Mehrschichtige Leiterplatte nach Anspruch 1 oder 2, wobei bei dem gefüllten Kontaktloch in der ersten Zwischenschicht-Harz-Isolierschicht die Ausdehnung eines Höckers eines Mittelteils vom oberen Ende 7 µm oder weniger vom Umfangsteil her beträgt.

## Revendications

1. Carte de câblage imprimé multicouche, dans laquelle une première couche d'isolation intercouche en résine (50), présentant plusieurs traversées remplies (60) comprenant un film de déposition autocatalytique et un film de déposition électrolytique, et un circuit de conducteurs sont disposés en couches sur un substrat central (30) présentant un trou traversant (36), et dans laquelle une seconde couche d'isolation intercouche en résine (150), présentant plusieurs traversées remplies comprenant un film de déposition autocatalytique et un film de déposition électrolytique, et un circuit de conducteurs sont disposés en couches sur la première couche d'isolation intercouche en résine (50), **caractérisée en ce que**
une couche de conducteurs analogue à une enveloppe (36) est formée à une extrémité du trou traversant (36) pour obturer l'extrémité ;
une partie d'une traversée remplie (60) dans ladite première couche d'isolation intercouche en résine (50) est placée à l'intérieur d'une couche de conducteurs de paroi latérale (3610) du trou traversant et sur la couche de conducteurs analogue à une enveloppe (36) ;
l'autre partie de la traversée remplie (60) dans ladite première couche d'isolation intercouche en résine (50) est placée à l'extérieur de la couche de conducteurs de paroi latérale (3610) du trou traversant et sur la couche de conducteurs analogue à une enveloppe (36) ;
un diamètre de fond d'une traversée remplie (160) dans la seconde couche d'isolation intercouche (150) formée directement au-dessus de la traversée remplie (60) dans la première couche d'isolation intercouche (50) est fabriqué plus petit qu'un diamètre de fond de la traversée remplie dans la première couche d'isolation intercouche (50), et le diamètre du trou traversant est fabriqué plus grand que le diamètre de fond de la traversée remplie dans la première intercouche d'isolation.

2. Carte de câblage imprimé multicouche selon la revendication 1, dans laquelle la traversée remplie dans la première couche d'isolation intercouche en résine présente un creux dont l'étendue d'une partie centrale depuis l'extrémité supérieure est de 7 µm ou moins par rapport à une partie périphérique.

3. Carte de câblage imprimé multicouche selon la revendication 1 ou 2, dans laquelle la traversée remplie dans la première couche d'isolation intercouche en résine présente une bosse dont l'étendue d'une partie centrale depuis l'extrémité supérieure est de 7 µm ou moins par rapport à une partie périphérique.
